# DEMANDE DE BREVET EUROPEEN

(11) **EP 0 654 826 A1**
(43) Date de publication de la demande: **24.05.1995**
(21) Numéro de dépôt: 94402647.5
(22) Date de dépôt: 21.11.1994
(51) Int. Cl.: H01L 25/16, H01L 27/146

(54) **Détecteur de rayonnements dans deux bandes de longeurs d'ondes et procédé de fabrication de ce détecteur**

(30) Priorité: 23.11.1993 FR 9313992
(71) Demandeur: COMMISSARIAT A L'ENERGIE ATOMIQUE, F-75015 Paris (FR)
(72) Inventeur: Mathieu, Lydie, F-38340 Voreppe (FR); Marion, François, F-38120 Saint Egreve (FR); Lucas, Christian, F-38120 Saint Egreve (FR)
(74) Mandataire: Dubois-Chabert, Guy

(57) **Abrégé**

Selon l'invention, on fabrique un premier substrat (20) où est formé au moins un premier élément de photodétection (22) sensible à une première bande de longueurs d'ondes et un deuxième substrat (24) où est formé au moins un deuxième élément de photodétection (26) sensible à une deuxième bande de longueurs d'ondes. Le deuxième substrat muni du deuxième élément de photodétection est transparent au moins à la première bande de longueurs d'ondes et le premier élément est placé en regard du deuxième, au voisinage de ce dernier. Les premier et deuxième substrat sont reliés l'un à l'autre par des billes de connexion électrique et/ou mécanique.

Application à l'imagerie thermique.

## Description

La présente invention concerne un détecteur de rayonnements dans deux bandes de longueurs d'ondes ainsi qu'un procédé de fabrication de ce détecteur.

L'invention s'applique notamment à l'imagerie thermique.

On sait que l'imagerie thermique permet une représentation d'objets par leurs émissions thermiques.

L'énergie propre émise par un objet dépend de deux grandeurs, à savoir l'émissivité εo et la température To de l'objet.

Une mesure thermique, effectuée dans deux bandes de longueurs d'ondes, permet, en résolvant une équation à deux inconnues, de déterminer To et εo.

Les systèmes d'imagerie, aptes à lire deux bandes spectrales, ont donc un intérêt important en imagerie thermique.

Des détecteurs de rayonnements dans deux bandes de longueurs d'ondes, encore appelés "détecteurs bicolores", ont déjà été divulgués en vue de la réalisation de caméras bispectrales.

Une telle caméra, constituée par un analyseur bispectral AGA THV 780 fonctionnant dans la bande allant de 3 à 5,5 µm et dans la bande allant de 8 à 12 µm, est décrite dans le livre intitulé "Thermographie infrarouge", G. Gaussorgues, TEC et Doc, Editions Lavoisier.

Dans cet analyseur connu, les deux voies d'analyse sont spatialement séparées au niveau des moyens optiques de l'analyseur qui résulte en fait de la juxtaposition de deux caméras.

La présente invention résout le problème du positionnement, dans un cube de tolérance et aussi près que possible l'un de l'autre, de deux éléments de photodétection, ou pixels de détection, qui sont respectivement sensibles à deux domaines distincts de longueurs d'ondes.

Il s'agit de localiser spatialement ces pixels dans un volume de tolérance parfaitement déterminé suivant trois axes X, Y et Z perpendiculaires les uns aux autres.

Les techniques connues de la microélectronique ne permettent pas de former des pixels "planars" sur un même substrat.

Pour résoudre le problème mentionné ci-dessus, il est connu de réaliser respectivement les pixels sur des substrats séparés puis de découper les circuits de détection ainsi obtenus et d'assembler mécaniquement ces circuits de détection en les juxtaposant.

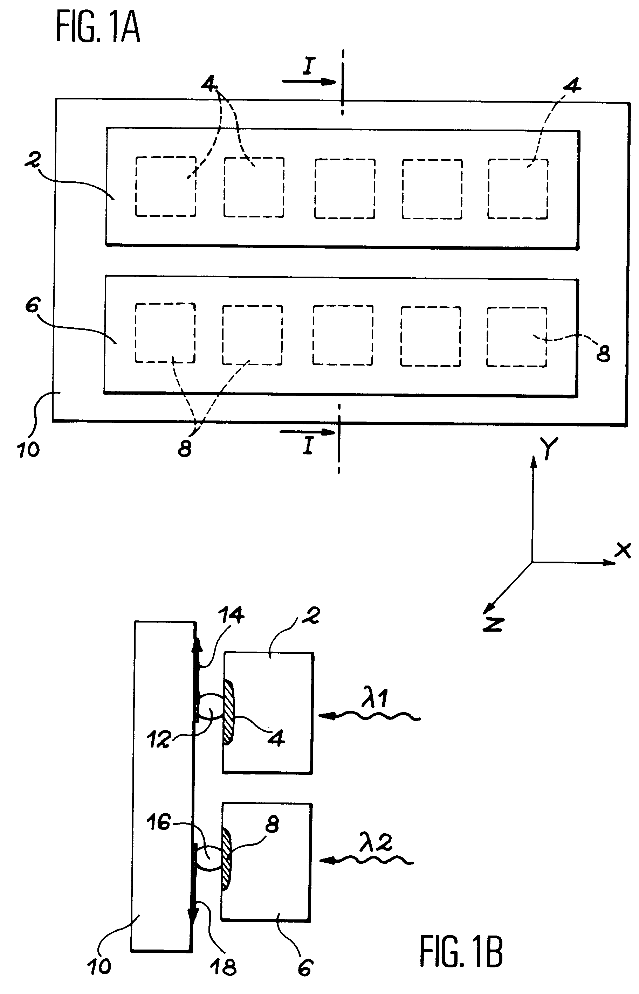

Ceci est schématiquement illustré par les figures 1A et 1B.

On voit sur ces figures 1A et 1B un circuit de détection constitué par une barrette 2 de photodétecteurs 4 et un autre circuit de détection constitué par une autre barrette 6 de photodétecteur 8, ces photodétecteurs 4 et 8 étant par exemple constitués par des photodiodes.

Ces barrettes 2 et 6 sont disposées de façon contiguë et sont assemblées sur un même substrat 10, par la technique dite "flip-chip".

La figure 1A montre une vue de dessus de l'assemblage obtenu tandis que la figure 1B est la coupe I-I de la figure 1A.

On définit des axes X, Y et Z, l'axe X étant parallèle aux barrettes de photodétecteurs, l'axe Y étant perpendiculaire à l'axe X et parallèle au plan du substrat 10 portant les barrettes 2 et 6 et l'axe Z étant perpendiculaire aux axes X et Y.

Des microbilles électriquement conductrices 12 permettent d'établir une liaison électrique entre les photodétecteurs 4 et des conducteurs de connexion 14 qui leur sont associés sur le substrat 10, et d'autres microbilles électriquement conductrices 16 permettent d'établir une liaison entre les photodétecteurs 8 et d'autres conducteurs de connexion 18 qui leur sont associés sur le substrat 10.

La barrette 2, dans laquelle sont formés les photodétecteurs 4, est sensible aux rayonnements appartenant à un premier domaine de longueurs d'ondes centré sur une longueur d'onde λ1.

La barrette 6, dans laquelle sont formées les photodétecteurs 8, est sensible aux rayonnements appartenant à un deuxième domaine de longueurs d'ondes qui est centré sur une longueur d'onde λ2 et distinct du premier domaine.

On obtient ainsi un assemblage de photodétecteurs 4 et 8 qui sont contigus et aptes à une lecture dans deux domaine de longueurs d'ondes, la lecture des barrettes 2 et 6 se faisant par balayage suivant l'axe Y.

Dans l'assemblage connu qui est schématiquement représenté sur les figures 1A et 1B, les photodétecteurs de la barrette 2 sont très éloignés des photodétecteurs de la barrette 6 (suivant l'axe Y) et cet éloignement impose de nombreuses corrections électroniques de lecture des barrettes et pose des problèmes optiques dûs à la plus grande taille du plan focal.

La présente invention vise à résoudre le problème mentionné plus haut tout en réduisant considérablement le nombre de corrections électroniques de lecture.

De façon précise, la présente invention a pour objet un détecteur de rayonnements dans deux bandes de longueurs d'ondes, ce détecteur comprenant :
- un premier substrat dans lequel est formé au moins un premier élément de photodétection qui est sensible aux rayonnements appartenant à une première bande de longueurs d'ondes,
- un deuxième substrat dans lequel est formé au moins un deuxième élément de photodétection qui est sensible aux rayonnements appartenant à une deuxième bande de longueurs d'ondes,

ce dispositif étant caractérisé en ce que le deuxième substrat muni du deuxième élément de photodétection est transparent au moins à la première bande de longueurs d'ondes et en ce que le premier élément de photodétection est placé en regard du deuxième élément de photodétection, au voisinage de ce dernier, et en ce que les premier et deuxième substrats sont reliés l'un à l'autre par des billes de connexion électrique et/ou mécanique.

Ces billes servent à la connexion mécanique des substrats ou à la connexion électrique des éléments de photodétection ou à la fois à ces connexions électrique et mécanique.

Selon un mode de réalisation particulier de l'invention, le deuxième substrat est non photoconducteur et transparent aux première et deuxième bandes de longueurs d'ondes.

Selon un autre mode de réalisation particulier, le deuxième substrat est photoconducteur et simplement transparent à la première bande de longueurs d'ondes.

Le premier substrat peut, quant à lui, être photoconducteur ou non photoconducteur.

Ainsi, quatre possibilités apparaissent : le deuxième substrat peut être photoconducteur ou non et, dans ces deux cas, le premier substrat peut être photoconducteur ou non.

L'invention permet de superposer, dans un cadre de tolérances extrêmement réduites, deux pixels de détection qui sont respectivement sensibles à des domaines de longueurs d'ondes distincts.

Selon un mode de réalisation particulier du détecteur objet de l'invention, le premier substrat comporte une pluralité de premiers éléments de photodétection, le deuxième substrat comporte une pluralité de deuxièmes éléments de photodétection, les deuxièmes éléments de photodétection étant placés respectivement en regard des premiers éléments de photodétection, au voisinage de ces derniers.

Le premier substrat peut comporter une rangée de premiers éléments de photodétection, le deuxième substrat comportant, quant à lui, une rangée de deuxièmes éléments de photodétection.

Selon un mode de réalisation préféré du détecteur objet de l'invention, ce détecteur comprend en outre un support qui est pourvu d'un évidement apte à recevoir le deuxième substrat et qui comporte un premier conducteur électrique de liaison pour chaque premier élément de photodétection et un deuxième conducteur électrique de liaison pour chaque deuxième élément de photodétection, chaque premier élément de photodétection est relié au premier conducteur électrique de liaison correspondant par l'intermédiaire d'une première bille électriquement conductrice, chaque deuxième élément de photodétection est relié au deuxième conducteur électrique de liaison correspondant par l'intermédiaire de deuxième et troisième billes électriquement conductrices elles-mêmes reliées l'une à l'autre par l'intermédiaire d'un troisième conducteur électrique de liaison dont est muni le premier substrat.

Chaque premier élément de photodétection peut être sensible aux rayonnements appartenant à une première bande de longueurs d'ondes du domaine infrarouge, chaque deuxième élément de photodétection étant alors sensible aux rayonnements appartenant à une deuxième bande de longueurs d'ondes également du domaine infrarouge.

La présente invention a également pour objet un procédé de fabrication du détecteur conforme à l'invention qui comporte ledit support, ce procédé étant caractérisé en ce qu'il comprend les étapes suivantes :
- on fabrique ledit support pourvu dudit évidement,
- on fabrique ledit premier substrat portant chaque premier élément de photodétection et pourvu, pour chaque premier élément de photodétection, desdites première, deuxième et troisième billes électriquement conductrices,
- on fabrique ledit deuxième substrat portant chaque deuxième élément de photodétection,
- on assemble le premier substrat et le support en connectant chaque premier conducteur au premier élément de photodétection correspondant, par l'intermédiaire de la première bille correspondante, et en connectant chaque deuxième conducteur au troisième conducteur correspondant par l'intermédiaire de la deuxième bille correspondante, et
- on assemble le deuxième substrat et l'ensemble ainsi obtenu, comportant le premier substrat et le support, en connectant chaque deuxième élément de photodétection à la troisième bille correspondante.

La présente invention sera mieux comprise à la lecture de la description d'exemples de réalisation donnés ci-après, à titre purement indicatif et nullement limitatif, en faisant référence aux dessins annexés sur lesquels :
· la figure 1A est une vue de dessus schématique d'un détecteur connu de rayonnements dans deux bandes de longueurs d'ondes et a déjà été décrite,
· la figure 1B est la coupe I-I de la figure 1A et a déjà été décrite,
· la figure 2A est une vue de dessus schématique d'un détecteur conforme à l'invention, et
· la figure 2B est la coupe II-II de la figure 2A.

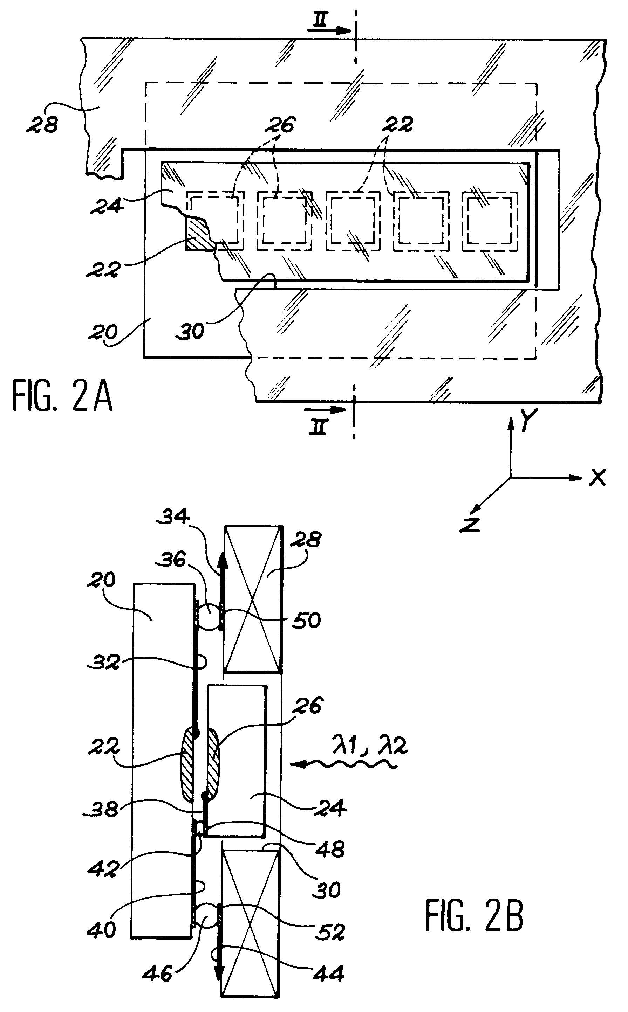

La détecteur conforme à l'invention qui est schématiquement représenté sur les figures 2A et 2B comprend :
- une première barrette 20 comprenant une rangée de photodétecteurs 22 qui sont sensibles aux rayonnements appartenant à un domaine de longueurs d'ondes qui est centré sur une longueur d'onde λ1,
- une deuxième barrette 24 comprenant une rangée de photodétecteurs 26 qui sont sensibles aux rayonnements appartenant à un autre domaine de longueurs d'ondes qui est centré sur une longueur d'onde λ2 différente de λ1, et
- un support de réseau d'interconnexion 28 sur lequel la barrette 20 est hybridée par des billes selon la technique flip-chip.

Les photodétecteurs 22 et 26 sont par exemple des photoconducteurs, des photodiodes ou encore des capacités MIS.

Le support 28 est muni d'un évidement 30 qui permet d'avoir accès à la face-avant de la barrette 20 après l'hybridation de celle-ci sur le support (les photodétecteurs 22 étant placés du côté de cette face-avant comme on le voit sur la figure 2B).

Les photodétecteurs 26 de la barrette 24 sont également placés du côté de la face-avant de celle-ci et cette barrette 24 est hybridée, à travers l'évidement 30 du support 28, sur la barrette 20, face contre face, les photodétecteurs 22 et 26 étant alors placés en vis-à-vis comme on le voit sur les figures 2A et 2B.

On voit sur la figure 2A que l'évidement 30 a la forme d'un rectangle dont la largeur est supérieure à celle de la barrette 24 et dont la longueur est supérieure à celle de cette barrette 24.

L'utilisation d'une hybridation par billes (électriquement conductrices) permet, compte tenu de la taille de ces billes qui peuvent avoir un diamètre de l'ordre de 5 à 10 µm, de placer les photodétecteurs 26 au voisinage immédiat des photodétecteurs 22.

On est ainsi capable de disposer ces photodétecteurs 22 et 26 très près les uns des autres, à une distance de l'ordre de 5 à 10 µm.

Ces photodétecteurs 22 et 26 peuvent même être placés en contact les uns avec les autres si des trous sont prévus dans l'une ou l'autre des barrettes 20 et 24 pour recevoir les billes permettant l'hybridation de la barrette 24 à la barrette 20, la réalisation de tels trous étant connue dans l'état de la technique.

On revient maintenant sur l'hybridation de la barrette 20 sur le support 28 et sur l'hybridation de la barrette 24 sur la barrette 20.

Comme on le voit sur la figure 2B, chaque photodétecteur 22 est muni d'un conducteur électrique de liaison 32 situé sur la barrette 20 et est associé à un conducteur électrique de liaison 34 disposé sur le support de réseau d'interconnexion 28, ces conducteurs 32 et 34 étant électriquement reliés par l'intermédiaire d'une bille électriquement conductrice 36.

On voit également sur la figure 2B que le photodétecteur 26 correspondant à ce photodétecteur 22 est muni d'un conducteur électrique de liaison 38 (placé sur la face-avant de la barrette 24) et associé à un autre conducteur de liaison 40 placé sur la barrette 20.

Une bille électriquement conductrice 42 assure la liaison entre les conducteurs 38 et 40.

Un autre conducteur électrique de liaison 44 est associé à ces conducteurs 38 et 40 et placé sur le support de réseau d'interconnexion 28.

Une autre bille électriquement conductrice 46 permet de connecter électriquement le conducteur 44 au conducteur 40.

Le signal électrique fourni par chaque photodétecteur 22 est transmis au conducteur 34 correspondant par l'intermédiaire du conducteur 32 et de la bille 36 correspondants.

De même, le signal électrique fourni par chaque photodétecteur 26 est transmis au conducteur 44 correspondant par l'intermédiaire du conducteur 38, de la bille 42, du conducteur 40 et de la bille 46 correspondants.

Les conducteurs 34 et 44 fournissent les signaux qu'ils reçoivent à des moyens électroniques de traitement non représentés.

Les domaines de longueurs d'ondes, auxquels les photodétecteurs 22 et 26 sont respectivement sensibles appartiennent par exemple au domaine infrarouge (il s'agit par exemple du domaine allant de 3 à 5,5 µm et du domaine allant de 8 à 12 µm).

Le substrat, qui constitue la barrette 24 et dans lequel sont formés les photodétecteurs 26, est non photoconducteur et transparent à ces deux domaines de longueurs d'ondes.

Ainsi, un signal infrarouge qui est situé dans le domaine centré sur λ2 et qui éclaire la face-arrière de la barrette 24, traverse celle-ci jusqu'aux photodétecteurs 26 qui détectent ce domaine de longueurs d'ondes.

Un signal infrarouge qui est situé dans le domaine centré sur λ1 n'est pas arrêté par les photodétecteurs 26 et sort de la barrette 24 pour venir "éclairer" les photodétecteurs 22 qui détectent ce signal.

Dans le cas où le substrat de la barrette 24 est un photoconducteur sensible au domaine centré sur la longueur d'onde λ2, il est transparent au seul domaine centré sur la longueur d'onde λ1.

Dans ce cas comme dans le cas où ce substrat est non photoconducteur, le substrat de la barrette 20 peut, quant à lui, être photoconducteur ou non.

Les avantages apportés par la présente invention sont les suivants :
- en considérant encore des axes X et Y perpendiculaires l'un à l'autre et parallèles aux plans des barrettes 20 et 24 et du support 28 et un axe Z perpendiculaire aux axes X et Y, la réalisation du détecteur conforme à l'invention, représenté sur les figures 2A et 2B, conduit à un décalage très faible (par exemple inférieur à 0,5 µm), suivant les axes X et Y, des pixels permettant respectivement de détecter les deux domaines de longueurs d'ondes,
- ce détecteur conduit à un décalage minimal de ces pixels suivant l'axe Z, ce décalage pouvant même être nul comme on l'a vu plus haut,
- l'invention permet de réaliser un détecteur dans trois bandes de longueurs d'ondes, encore appelé "détecteur tricolore", avec des pixels de détection très peu décalés suivant l'axe X et peu décalés suivant l'axe Y, en combinant la technique décrite en référence aux figures 1A et 1B et la présente invention.

En effet, il est possible de réaliser un tel détecteur tricolore
- en hybridant une barrette de photodétecteurs sensibles à une première gamme de longueurs d'ondes sur un support de réseau d'interconnexion comportant un évidement,
- en hybridant ensuite une autre barrette de photodétecteurs sensibles à une deuxième gamme de longueurs d'ondes sur cette première barrette, à travers l'évidement et en positionnant les photodétecteurs en face les uns des autres, comme on l'a vu plus haut (figures 2A et 2B), puis
- en hybridant une troisième barrette de photodétecteurs sensibles à une troisième bande de longueurs d'ondes sur la première barrette, à côté de la deuxième barrette, parallèlement à celle-ci, à travers l'évidement (ce dernier ayant des dimensions appropriées).

On décrit ci-après un procédé de fabrication du détecteur conforme à l'invention qui est représenté sur les figures 2A et 2B.

Pour réaliser ce détecteur, on commence par fabriquer le support de réseau d'interconnexion 28 pourvu de l'évidement 30.

Ce support peut être réalisé dans une céramique (auquel cas l'évidement est usiné mécaniquement) ou dans du silicium (auquel cas l'évidement est réalisé par un usinage chimique).

La réalisation d'un tel support pourvu d'un évidement est à la portée de l'homme du métier, les techniques de réalisation de ce genre de circuit percé ayant fait l'objet de nombreuses publications.

On fabrique ensuite la barrette 20 dans un matériau connu pour sa réponse dans la gamme spectrale centrée sur λ1 (on utilise par exemple CdHgTe pour une détection dans le domaine infrarouge).

La fabrication d'une telle barrette de photodétecteurs est également bien connue dans l'état de la technique.

Cette barrette est ensuite munie de billes de soudure du genre de celles qui sont utilisées dans les technologies flip-chip.

La réalisation de telles billes est également bien connue dans l'état de la technique (on procède à une électrolyse du matériau de soudure ou à une pulvérisation d'un tel matériau).

On précise que la barrette 20 est pourvue, pour chaque couple de photodétecteurs 22 et 26, d'au moins :
- la bille 36 destinée à interconnecter, au support 28, le photodétecteur 22 sensible à la gamme de longueurs d'ondes centrée sur λ1,
- la bille 42 destinée à interconnecter, à la barrette 20, le photodétecteur 26 sensible à la gamme de longueurs d'ondes centrée sur λ2,
- la bille 46 destinée à relier le conducteur 40 au conducteur 44.

On fabrique ensuite la barrette 24 de la même manière que la barrette 20, en munissant cette barrette 24 de plots de mouillage 48 destinés à se trouver en regard des billes 42.

On hybride ensuite, par la technique flip-chip, la barrette 20 sur le support de réseau d'interconnexion 28, une telle hybridation étant classique et largement utilisée en microélectronique.

On précise à ce propos que le support 28 est préalablement muni de plots de mouillage 50 et 52 destiné à se trouver respectivement en regard des billes 36 et 46.

On hybride ensuite la barrette 24 sur la barrette 20 à travers l'évidement 30 du support 28.

La présente invention s'applique à la fabrication de détecteurs multispectraux.

Il peut s'agir de barrettes balayées bicolores, de barrettes balayées tricolores et même de monoéléments (dans ce dernier cas, on dispose un premier photodétecteur sensible à une première gamme de longueurs d'ondes en regard d'un deuxième photodétecteur sensible à une deuxième gamme de longueurs d'ondes, par exemple en hybridant un substrat comportant le premier photodétecteur sur un autre substrat comportant le deuxième photodétecteur, à travers un évidement réalisé dans un support sur lequel cet autre substrat est lui-même hybridé).

On peut même envisager de fabriquer conformément à l'invention une petite matrice bicolore (par exemple de type 4x4 ou 8x8), chaque photodétecteur devant alors "repris" par un conducteur électrique pour être amené à la périphérie de la matrice.

Dans le cas des figures 2A et 2B, les billes de soudure servent de connexions mécaniques aux barrettes et de connexions électriques aux photodétecteurs de ces barrettes.

D'autres modes de réalisation de l'invention sont possibles, dans lesquels les billes de soudure servent seulement de connexions électriques aux photodétecteurs ou seulement de connexions mécaniques aux substrats.

## Revendications

1. Détecteur de rayonnements dans deux bandes de longueurs d'ondes, ce détecteur comprenant :
- un premier substrat (20) dans lequel est formé au moins un premier élément de photodétection (22) qui est sensible aux rayonnements appartenant à une première bande de longueurs d'ondes,
- un deuxième substrat (24) dans lequel est formé au moins un deuxième élément de photodétection (26) qui est sensible aux rayonnements appartenant à une deuxième bande de longueurs d'ondes,
ce dispositif étant caractérisé en ce que le deuxième substrat muni du deuxième élément de photodétection est transparent au moins à la première bande de longueurs d'ondes et en ce que le premier élément de photodétection est placé en regard du deuxième élément de photodétection, au voisinage de ce dernier, et en ce que les premier et deuxième substrats sont reliés l'un à l'autre par des billes de connexion mécanique et/ou électrique.

2. Détecteur selon la revendication 1, caractérisé en ce que le deuxième substrat (24) est non photoconducteur et transparent aux première et deuxième bandes de longueurs d'ondes.

3. Détecteur selon la revendication 1, caractérisé en ce que le deuxième substrat est photoconducteur et simplement transparent à la première bande de longueurs d'ondes.

4. Détecteur selon l'une quelconque des revendications 1 à 3, caractérisé en ce que le premier substrat est photoconducteur ou non photoconducteur.

5. Détecteur selon l'une quelconque des revendications 1 à 4, caractérisé en ce que le premier substrat (20) comporte une pluralité de premiers éléments de photodétection (22), en ce que le deuxième substrat (24) comporte une pluralité de deuxièmes éléments de photodétection (26), les deuxièmes éléments de photodétection étant placés respectivement en regard des premiers éléments de photodétection, au voisinage de ces derniers.

6. Détecteur selon la revendication 5, caractérisé en ce que le premier substrat (20) comporte une rangée de premiers éléments de photodétection (22) et en ce que le deuxième substrat (24) comporte une rangée de deuxièmes éléments de photodétection (26).

7. Détecteur selon l'une quelconque des revendications 1 à 6, caractérisé en ce qu'il comprend en outre un support (28) qui est pourvu d'un évidement (30) apte à recevoir le deuxième substrat (24) et qui comporte un premier conducteur électrique de liaison (34) pour chaque premier élément de photodétection (22), et un deuxième conducteur électrique de liaison (44) pour chaque deuxième élément de photodétection (26), en ce que chaque premier élément de photodétection (22) est relié au premier conducteur électrique de liaison correspondant (34) par l'intermédiaire d'une première bille (36) électriquement conductrice, et en ce que chaque deuxième élément de photodétection (26) est relié au deuxième conducteur électrique de liaison correspondant (44) par l'intermédiaire de deuxième (46) et troisième (42) billes électriquement conductrices elles-mêmes reliées l'une à l'autre par l'intermédiaire d'un troisième conducteur électrique de liaison (40) dont est muni le premier substrat (20).

8. Détecteur selon l'une quelconque des revendications 1 à 7, caractérisé en ce que chaque premier élément de photodétection (22) est sensible aux rayonnements appartenant à une première bande longueurs d'ondes du domaine infrarouge et en ce que chaque deuxième élément de photodétection (26) est sensible aux rayonnements appartenant à une deuxième bande de longueurs d'ondes également du domaine infrarouge.

9. Procédé de fabrication du détecteur selon la revendication 7, caractérisé en ce qu'il comprend les étapes suivantes :
- on fabrique ledit support (28) pourvu dudit évidement (30),
- on fabrique ledit premier substrat (20) portant chaque premier élément de photodétection (22) et pourvu, pour chaque premier élément de photodétection, desdites première (36), deuxième (46) et troisième (42) billes électriquement conductrices,
- on fabrique ledit deuxième substrat (24) portant chaque deuxième élément de photodétection (26),
- on assemble le premier substrat (20) et le support (28) en connectant chaque premier conducteur (34) au premier élément de photodétection (22) correspondant, par l'intermédiaire de la première bille correspondante (36), et en connectant chaque deuxième conducteur (44) au troisième conducteur correspondant (40), par l'intermédiaire de la deuxième bille correspondante (46), et
- on assemble le deuxième substrat (24) et l'ensemble ainsi obtenu, comportant le premier substrat (20) et le support (28), en connectant chaque deuxième élément de photodétection (26) à la troisième bille correspondante (42).
